# EUROPEAN PATENT SPECIFICATION

(11) **EP 3 923 466 B1**
(45) Date of publication and mention of the grant of the patent: **13.12.2023**
(21) Application number: 20919995.9
(22) Date of filing: 15.05.2020
(51) Int. Cl.: H02S 20/25, H01L 31/05, H01L 31/049

(54) **SOLAR TILE STRUCTURE**
SOLARDACHZIEGELSTRUKTUR
STRUCTURE DE TUILE SOLAIRE

(30) Priority: 17.02.2020 CN 202010096794; 17.02.2020 CN 202020176797 U
(43) Date of publication of application: 15.12.2021
(73) Proprietor: Hengdian Group DMEGC Magnetics Co., Ltd., Dongyang, Zhejiang 322118 (CN)
(72) Inventor: LU, Jiangkai, Jinhua, Zhejiang 322118 (CN); LOU, Caoxin, Jinhua, Zhejiang 322118 (CN); LI, Xiaoxia, Jinhua, Zhejiang 322118 (CN); WANG, Tingting, Jinhua, Zhejiang 322118 (CN)
(74) Representative: Cabinet Beaumont
(86) International application number: PCT/CN2020/090455
(87) International publication number: WO 2021/164141

(56) References cited:
- CN-A- 106 558 630
- CN-A- 108 123 007
- CN-A- 108 560 840
- CN-A- 108 560 840
- CN-A- 108 767 029
- CN-A- 108 767 029
- CN-A- 109 285 905
- CN-U- 201 620 532
- CN-U- 201 620 532
- CN-U- 201 975 400
- CN-U- 204 857 751
- CN-U- 204 927 313
- CN-U- 209 183 559
- JP-A- 2000 073 498
- US-A1- 2002 036 010
- US-A1- 2008 302 030
- US-A1- 2019 140 582

## Description

### TECHNICAL FIELD

The present application relates to the field of solar energy technologies, for example, to a solar tile structure.

### BACKGROUND

In order to increase the ability of a building to generate power resources, in the related art, a solar power system is typically integrated on roofs or windows. For a solar power system installed on the roofs, a solar cell module is typically installed on the roofs through a mounting bracket.

However, in this manner, the solar cell module is typically installed on the roofs through the mounting bracket after the construction of the roofs is completed so that a lot of time to install the solar cell module is required. As a result, it is not conducive to saving the installation cost, and the tiles of the roofs are extremely easy to be damaged in a process of installing the solar cell module. Moreover, the solar cell module is not easy to disassemble after installation, and the difficulty of maintenance is increased. An example of a photovoltaic cell module tile in which the photovoltaic cell module is detachably fixed to a tile body and one photovoltaic cell module can easily be replaced when it is broken is disclosed in the application US 2002/0036010 A1. An example of an improved BIPV roofing tile which simplifies the configuration and reduces the materials costs associated with photovoltaic roofing elements which is disclosed in the application US 2008/0302030 A1. Patent application JP2000073498A discloses also a photovoltaic roofing tile.

### SUMMARY

The present application provides a solar tile structure which can implement the integrated arrangement of a solar cell module and a tile as defined in the attached independent claim, so that the convenience and efficiency of disassembly and assembly is improved and the cost of installation and maintenance is reduced. Further improvements are provided in the dependent claims.

According to the invention there is provided a solar tile structure, and the solar tile structure includes a solar cell module and a tile. The tile has a first side surface and a second side surface arranged oppositely in a thickness direction of the tile, the first side surface is provided with an embedding groove, and the solar cell module is embedded in the embedding groove.

The tile is provided with a disassembly hole, and the disassembly hole is configured to enable the solar cell module to be detached from the embedding groove.

The solar cell module 2 comprises transparent glass 23, a cell pack 24 and a back panel 25 which are sequentially stacked in a direction from the first side surface to the second side surface, and two side surfaces of the cell pack 24 in a thickness direction of the cell pack 24 are respectively bonded to the transparent glass 23 and the back panel 25.

The cell pack 24 has a positive cable 21 and a negative cable 22, and the positive cable 21 and the negative cable 22 are located at a same end of the cell pack 24 in a length direction of the cell pack 24.

The disassembly hole is located where a side wall of the embedding groove 11 contacts the first side surface, the side wall extending along the length direction.

### BRIEF DESCRIPTION OF DRAWINGS

FIG. 1 is an exploded view of a solar tile structure according to an embodiment of the present application;
FIG. 2 is a schematic diagram illustrating the connection in a battery string according to an embodiment of the present application;
FIG. 3 is a schematic diagram illustrating a positive cable, a negative cable and a junction box according to an embodiment of the present application;
FIG. 4 is a schematic diagram illustrating the assembly of a tile and a batten according to an embodiment of the present application;
FIG. 5 is a structural view of a solar cell module according to an embodiment of the present application; and
FIG. 6 is a schematic diagram of a first transparent coating film, a second transparent coating film and transparent glass according to an embodiment of the present application.

### Reference list

- 1: tile
- 11: embedding groove
- 12: disassembly hole
- 13: mounting hole
- 14: protrusion
- 15: groove
- 16: assembly hole
- 2: solar cell module
- 20: battery string
- 201: cell
- 21: positive cable
- 22: negative cable
- 23: transparent glass
- 231: first transparent coating film
- 232: second transparent coating film
- 24: cell pack
- 25: back panel
- 251: first black coating
- 3: black shielding strip
- 31: second black coating
- 4: junction box
- 5: batten

### DETAILED DESCRIPTION

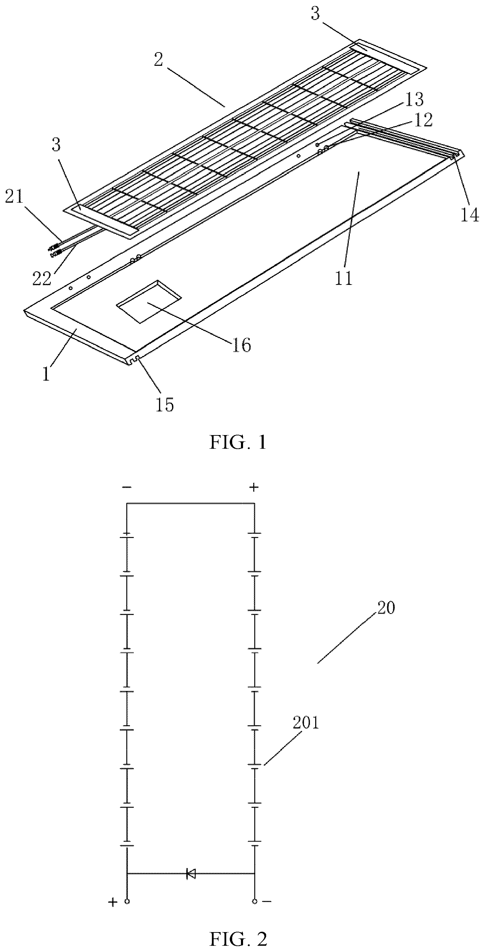

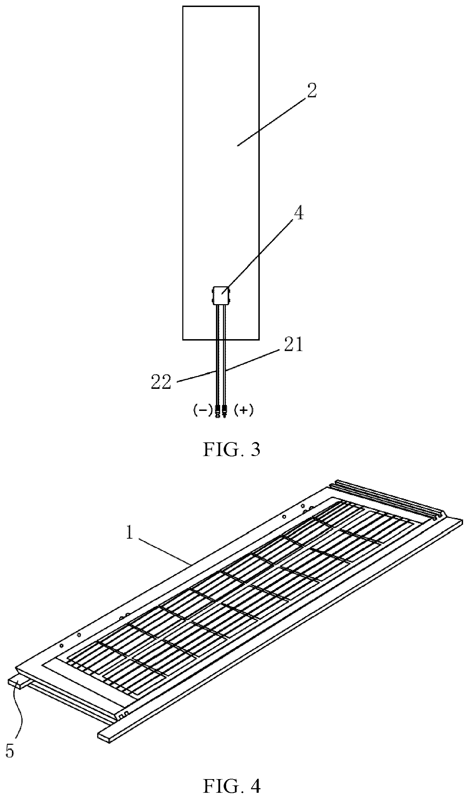

As shown in FIGS. 1 to 3, this embodiment provides a solar tile structure, and the solar tile structure includes a solar cell module 2 and a tile 1. In this embodiment, as shown in FIG. 4, the tile 1 is detachably connected to the batten 5. Exemplarily, a plurality of criss-cross wooden strips are connected to form the batten 5, the tile 1 is provided with mounting holes 13, and fasteners such as screws pass through the mounting holes 13 and are screwed into the wooded strips so that the tile 1 is detachably connected to the batten 5.

The tile 1 has a first side surface and a second side surface arranged oppositely in a thickness direction of the tile 1, the first side surface is provided with an embedding groove 11, and the solar cell module 2 is embedded in the embedding groove 11. A position where at least one side wall of the embedding groove 11 contacts the first side surface is provided with a disassembly hole 12, and the disassembly hole 12 is configured to enable the solar cell module 2 to be detached from the embedding groove 11.

In this embodiment, the embedding groove 11 has a first side wall, a second side wall and a third side wall which are connected in sequence. The first side wall is parallel to the third side wall and perpendicular to the second side wall. A position where the second side wall contacts the first side surface is provided with the disassembly hole 12. When the solar cell module 2 is disassembled, a finger or a disassembling tool or the like is inserted into the disassembly hole 12, and the solar cell module 2 is toggled to a side where the first side surface is located so that one end of the solar cell module 2 is separated from the embedding groove 11, and then the solar cell module 2 is manually taken out from the embedding groove 11.

In other embodiments, a disassembly hole 12 extending along a thickness direction of the solar cell module 2 may further be disposed on the tile 1, and the disassembly hole 12 penetrates one of the side walls of the embedding groove 11 and an outer wall of the tile 1 parallel to the side wall. When the solar cell module 2 is disassembled, a finger or a columnar disassembly tool or the like is inserted into the disassembly hole 12 from the outer wall of the tile 1 and abuts against the solar cell module 2, and the solar cell module 2 is toggled to the side where the first side surface is located so that one end of the solar cell module 2 is separated from the embedding groove 11, and then the solar cell module 2 is manually taken out from the embedding groove 11.

In this embodiment, the tile 1 is provided with the embedding groove 11, and the solar cell module 2 is embedded in the embedding groove 11, so that the installation mode is simple and the integrated arrangement of the solar cell module 2 and the tile 1 is implemented. In this manner, the solar tile 1 can be directly installed on the roof when the roof is built, and a mounting bracket for installing the solar cell module 2 on the tile 1 does not need to be individually provided, so that the structure is simple and the cost is low.

In this embodiment, the position where the at least one side wall of the embedding groove 11 contacts the first side surface is provided with the disassembly hole 12, one end of the disassembling tool or the finger or the like is inserted into the disassembly hole 12 and acted on the solar cell module 2 so that the solar cell module 2 is separated from the embedding groove 11. The disassembly is convenient and quick and it is convenient to replace the solar cell module 2 so that the difficulty of maintenance is reduced. Moreover, the tile 1 does not need to be provided with a through hole so that the water leakage of the roof can be effectively avoided.

In this embodiment, the mounting hole 13 is disposed in a region of the first side surface where the embedding groove 11 is not disposed, so as to prevent the solar cell module 2 from interfering with the connection between the tile 1 and the batten 5.

Optionally, the tile 1 is provided with a protrusion 14 and a groove 15, the protrusion 14 is configured to be connected to a groove 15 on another tile 1 adjacent to the tile 1 by inserting, and the groove 15 is configured to be connected to a protrusion 14 on another tile 1 adjacent to the tile 1 by inserting. Exemplarily, one of the groove 15 and the protrusion 14 is disposed on the first side surface of the tile 1, and the other one of the groove 15 and the protrusion 14 is disposed on the second side surface.

In the process of actually building the roof, a plurality of tiles 1 are required, two adjacent tiles 1 are typically connected to each other in an overlapping mode, and the stability of connection between the two adjacent tiles 1 is improved in a mode in which the protrusion 14 is inserted into the groove 15; and at the same time, two adjacent solar cell modules 2 are seamlessly spliced with each other, thereby effectively preventing the water leakage of the roof.

Exemplarily, the solar cell module 2 includes transparent glass 23, a cell pack 24 and a back panel 25 which are sequentially stacked in a direction from the first side surface to the second side surface, and two side surfaces of the cell pack 24 in a thickness direction of the cell pack 24 are respectively bonded to the transparent glass 23 and the back panel 25 by using ethylene-vinyl acetate copolymer. The ethylene-vinyl acetate copolymer between the transparent glass 23 and the cell pack 24 forms a first encapsulation layer, and the ethylene-vinyl acetate copolymer between the cell pack 24 and the back panel 25 forms a second encapsulation layer. In the process of actually forming the solar cell module 2, the transparent glass 23, the first encapsulation layer, the cell pack 24, the second encapsulation layer, and the back panel 25 are sequentially stacked, and then the solar cell module 2 is formed by using a lamination process.

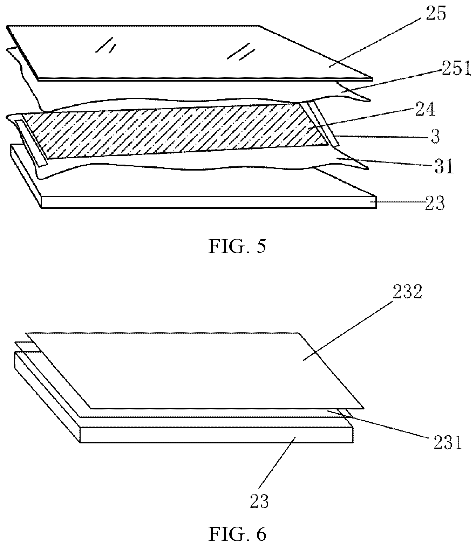

The back panel 25 is a polyvinylidene fluoride film-polyethylene terephthalate film-fluorine film composite plate (hereinafter referred to as a KPF plate), that is, the back panel 25 includes the polyvinylidene fluoride (PVDF) film, the polyethylene terephthalate (PET) film, and the fluorine film which are sequentially stacked, and the fluorine film is disposed facing the solar cell module 2 during installation. In this embodiment, as shown in FIG. 5, a side of the back panel 25 facing the cell pack 24 is formed with a first black coating 251 which can reduce glare pollution and improve the aesthetic effect of the solar tile structure.

In this embodiment, a side of the back panel 25 facing away from the solar cell module 2 may be provided with a white coating film, or no treatment may be performed on the side. The above two manners can improve the heat dissipation effect of the solar cell module 2 while ensuring the aesthetic performance of the whole solar tile structure. In other embodiments, a side of the back panel 25 facing away from the solar cell module 2 may also be provided with the first black coating 251, but the heat dissipation effect of the solar cell module 2 is reduced.

Optionally, the cell pack 24 includes a plurality of battery strings 20 arranged in sequence, and the plurality of battery strings 20 are arranged in parallel through a bus bar. A side of the cell pack 24 facing the transparent glass 23 is provided with black shielding strips 3, the black shielding strips 3 are disposed on two sides of the cell pack 24 in a length direction of the cell pack 24, and at least the side of the black shielding strip 3 facing the transparent glass 23 is formed with a second black coating 31.

In this embodiment, the black shielding strip 3 is a fluorine film-polyethylene terephthalate film-fluorine film composite plate (hereinafter referred to as FPF plate), that is, the black shielding strip 3 includes one fluorine film, the PET film and another fluorine film which are sequentially stacked. The side of the black shielding strip 3 facing the transparent glass 23 is formed with the second black coating 31 so that the glare pollution can be better reduced. In this embodiment, it is not required whether a film is applied on side surfaces of the black shielding strip 3 other than the side surface facing the transparent glass 23.

In this embodiment, the back panel 25 is configured to be a KPF plate, and the black shielding strip 3 is configured to be a FPF plate. In one embodiment, when the back panel 25 is a KPF plate, the black shielding strip 3 may not configured as a FPF plate; and when the black shielding strip 3 is a FPF plate, the back panel 25 may not configured as a KPF plate.

Generally, a thickness of the back panel 25 is greater than 290 µm ± 30 µm. In order to reduce the color difference between the black shielding strip 3 and the back panel 25, in this embodiment, a thickness of the black shielding strip 3 is 133µm ± 30 µm. A too low thickness of the black shielding strip 3 leads to serious color difference between the black shielding strip 3 and the back panel 25; and a too high thickness of the black shielding strip 3 leads to more process problems of the solar cell module 2 and existence of bubbles inside the black shielding strip 3.

In this embodiment, low-iron tempered embossed glass is selected to serve as the transparent glass 23 to respond to complicated weather conditions so as to effectively protect the cell pack 24. Optionally, a side of the transparent glass 23 facing away from the cell pack 24 is provided with a double-layer coating film. For example, as shown in FIG. 6, the side of the transparent glass 23 facing away from the cell pack 24 is formed with a first transparent coating film 231 and a second transparent coating film 232 which are sequentially stacked, a thickness of the first transparent coating film 231 is 85 µm to 100 µm, and a thickness of the second transparent coating film 232 is 75 µm to 90 µm. The transparent glass 23 is coated so that power of the solar cell module 2 is increased.

In this embodiment, the thickness of the first transparent coating film 231 is 85 µm to 100 µm, and the thickness of the second transparent coating film 232 is 75 µm to 90 µm. In one embodiment, when the thickness of the first transparent coating film 231 is 85 µm to 100 µm, the thickness of the second transparent coating film 232 may not be set to be 75 µm to 90 µm; and when the thickness of the second transparent coating film 232 is 75 µm to 90 µm, the thickness of the first transparent coating film 231 may not be set to be 85 µm to 100 µm.

In other embodiments, the transparent glass 23 may also not be coated so that the coating film on the transparent glass 23 is prevented from being scratched, and the color difference between a plurality of components in the solar cell module 2 is reduced, thereby improving the appearance of the solar cell module 2.

Each battery string 20 includes a plurality of cells 201 connected in series sequentially. Since cells 201 of different models have different colors, in order to make the color of the entire solar cell module 2 consistent and improve the aesthetic effect, in this embodiment, colors of cells 201 selected as dark as possible. For example, cells that are classified into D-color cells and D1-color cells in the professional field may be selected.

Exemplarily, as shown in FIGS. 2 and 3, the cell pack 24 has a positive cable 21 and a negative cable 22, and the positive cable 21 and the negative cable 22 are located at a same end in the length direction of the cell pack 24 so as to facilitate wiring connection between two adjacent solar tile structures. In this embodiment, a side of the back panel 25 facing away from the cell pack 24 is provided with a junction box 4 electrically connected to the cell pack 24, and the junction box 4 is electrically connected to the positive cable 21 and the negative cable 22. In order to facilitate the installation of the junction box 4, in this embodiment, a position of the tile 1 facing directly to the junction box 4 is provided with an assembly hole 16.

Each battery string 20 includes adjacent two rows of cells 201, distribution of anodes and cathodes of cells 201 in the same row is the same, and distribution of anodes and cathodes of the two rows of cells 201 of the same battery string 20 are opposite, so that the two rows of cells 201 are connected in series to form a battery string 20, an anode and a cathode of the battery string 20 are connected to the junction box 4, and an anode and a cathode of the junction box 4 are connected to the positive cable 21 and the negative cable 22 respectively.

In the solar tile structure provided by the present application, the tile 1 is provided with the embedding groove 11, and the solar cell module 2 is embedded in the embedding groove 11, so that the installation mode is simple and the integrated arrangement of the solar cell module 2 and the tile 1 is implemented. In this manner, the solar tile can be directly installed on the roof when the roof is built, and the mounting bracket for installing the solar cell module 2 on the tile 1 does not need to be separately provided, so that the structure is simple and the cost is low. In the present application, the tile 1 is provided with the disassembly hole 12, one end of the disassembling tool or the finger or the like is inserted into the disassembly hole 12 and acted on the solar cell module 2 so that the solar cell module 2 is separated from the embedding groove 11. The disassembly is convenient and quick and it is convenient to replace the solar cell module 2 so that the difficulty of maintenance is reduced.

In the description of the present application, it is to be noted that the orientational or positional relationships indicated by terms "center", "above", "below", "left", "right", "vertical", "horizontal", "inside", "outside" and the like are based on the orientational or positional relationships illustrated in the drawings, which are for the mere purpose of facilitating and simplifying the description of the present application, and these relationships do not indicate or imply that the device or component referred to has a specific orientation and is constructed and operated in a specific orientation, and thus it is not to be construed as limiting the present application. Moreover, terms like "first" and "second" are merely used for the description and not to be construed as indicating or implying relative importance. The terms "first position" and "second position" are two different positions.

In the description of the present application, it is to be noted that unless otherwise expressly specified and limited, terms like "mounted", "connected to each other", "connected" are to be construed in a broad sense, for example, as permanently connected, detachably connected or integrally connected; mechanically connected or electrically connected; directly connected or indirectly connected via an intermediate medium; or internally connected of two elements. For those of ordinary skill in the art, specific meanings of the above terms in the present application may be understood based on specific circumstances.

## Claims

1. A solar tile structure, comprising: a solar cell module (2) and a tile (1), wherein the tile (1) has a first side surface and a second side surface arranged oppositely in a thickness direction of the tile (1), the first side surface is provided with an embedding groove (11), and the solar cell module (2) is embedded in the embedding groove (11); and
the tile (1) is provided with a disassembly hole (12), and the disassembly hole (12) is configured to enable the solar cell module (2) to be detached from the embedding groove (11);
wherein the solar cell module (2) comprises transparent glass (23), a cell pack (24) and a back panel (25) which are sequentially stacked in a direction from the first side surface to the second side surface, and two side surfaces of the cell pack (24) in a thickness direction of the cell pack (24) are respectively bonded to the transparent glass (23) and the back panel (25);
the solar tile structure is **characterized in that** the cell pack (24) has a positive cable (21) and a negative cable (22), and the positive cable (21) and the negative cable (22) are located at a same end of the cell pack (24) in a length direction of
the cell pack (24); and
the disassembly hole (12) is located at a position where one side wall of the embedding groove contacts the first side surface, said side wall extending along the length direction.

2. The solar tile structure of claim 1, wherein a position of the first side surface where the embedding groove (11) is not disposed is provided with a mounting hole (13) penetrating through the tile (1), and the mounting hole (13) is configured to detachably connect the tile (1) to a batten (5) via a fastener.

3. The solar tile structure of claim 1, wherein the tile (1) is provided with a protrusion (14) and a groove (15), the protrusion (14) is configured to be connected to a groove (15) on another tile (1) adjacent to the tile (1) by inserting, and the groove (15) is configured to be connected to a protrusion (14) on another tile (1) adjacent to the tile (1) by inserting.

4. The solar tile structure of claim 3, wherein one of the groove (15) and the protrusion (14) is disposed on the first side surface, and the other one of the protrusion (14) and the groove (15) is disposed on the second side surface.

5. The solar tile structure of claim 1, wherein the cell pack (24) comprises a plurality of battery strings (20) arranged in sequence, and the plurality of battery strings (20) are arranged in parallel through a bus bar.

6. The solar tile structure of claim 1, wherein a side of the back panel (25) facing the cell pack (24) is formed with a first black coating (251), and a thickness of the back panel (25) is greater than 260 µm; and
a side of the cell pack (24) facing the transparent glass (23) is provided with a black shielding strip (3), a side of the black shielding strip (3) facing the transparent glass (23) is formed with a second black coating (31), and a thickness of the black shielding strip (3) is 133µm ± 30 µm.

7. The solar tile structure of claim 6, wherein the back panel (25) is a polyvinylidene fluoride film-polyethylene terephthalate film-fluorine film composite plate.

8. The solar tile structure of claim 6 or 7, wherein the black shielding strip (3) is a fluorine film-polyethylene terephthalate film-fluorine film composite plate.

9. The solar tile structure of claim 1, wherein a side of the transparent glass (23) facing away from the cell pack (24) is formed with a first transparent coating film (231) and a second transparent coating film (232) which are sequentially stacked; and
a thickness of the first transparent coating film (231) is 85 µm to 100 µm; or
a thickness of the second transparent coating film (232) is 75 µm to 90 µm; or
a thickness of the first transparent coating film (231) is 85 µm to 100 µm, and a thickness of the second transparent coating film (232) is 75 µm to 90 µm.

## Patentansprüche

1. Eine Solarziegelstruktur, die Folgendes aufweist: ein Solarzellenmodul (2) und einen Ziegel (1), wobei der Ziegel (1) eine erste Seitenfläche und eine zweite Seitenfläche aufweist, die in einer Dickenrichtung des Ziegels (1) gegenüberliegend angeordnet sind, die erste Seitenfläche mit einer Einbettungsnut (11) versehen ist und das Solarzellenmodul (2) in die Einbettungsnut (11) eingebettet ist; und der Ziegel (1) mit einem Demontageloch (12) versehen ist, und das Demontageloch (12) so konfiguriert ist, dass es dem Solarzellenmodul (2) ermöglicht, aus der Einbettungsrille (11) gelöst zu werden;
wobei das Solarzellenmodul (2) transparentes Glas (23), ein Zellenpaket (24) und eine Rückwand (25) aufweist, die aufeinanderfolgend in einer Richtung von der ersten Seitenfläche zur zweiten Seitenfläche gestapelt sind, und zwei Seitenflächen des Zellenpakets (24) in einer Dickenrichtung des Zellenpakets (24) jeweils mit dem transparenten Glas (23) und der Rückwand (25) verbunden sind;
die Solarziegelstruktur **dadurch gekennzeichnet ist, dass** das Zellenpaket (24) ein positives Kabel (21) und ein negatives Kabel (22) aufweist, und das positive Kabel (21) und das negative Kabel (22) an einem gleichen Ende des Zellenpakets (24) in einer Längsrichtung des Zellenpakets (24) angeordnet sind; und das Demontageloch (12) sich an einer Stelle befindet, an der eine Seitenwand der Einbettungsrille die erste Seitenfläche berührt, wobei sich die Seitenwand entlang der Längsrichtung erstreckt.

2. Solarziegelstruktur nach Anspruch 1, wobei eine Position der ersten Seitenfläche, an der die Einbettungsnut (11) nicht angeordnet ist, mit einem Montageloch (13) versehen ist, das den Ziegel (1) durchdringt, und das Montageloch (13) so konfiguriert ist, dass es den Ziegel (1) über ein Befestigungsmittel lösbar mit einer Leiste (5) verbindet.

3. Solarziegelstruktur nach Anspruch 1, wobei der Ziegel (1) mit einem Vorsprung (14) und einer Nut (15) versehen ist, wobei der Vorsprung (14) so konfiguriert ist, dass er mit einer Nut (15) auf einem anderen Ziegel (1), der an den Ziegel (1) angrenzt, durch Einsetzen verbunden wird, und wobei die Nut (15) so konfiguriert ist, dass sie mit einem Vorsprung (14) auf einem anderen Ziegel (1), der an den Ziegel (1) angrenzt, durch Einsetzen verbunden wird.

4. Solarziegelstruktur nach Anspruch 3, wobei eine der Rillen (15) und der Vorsprung (14) auf der ersten Seitenfläche und die andere der Vorsprünge (14) und der Rillen (15) auf der zweiten Seitenfläche angeordnet ist.

5. Solarziegelstruktur nach Anspruch 1, wobei das Zellenpaket (24) eine Vielzahl von Batteriesträngen (20) aufweist, die in Folge angeordnet sind, und die Vielzahl von Batteriesträngen (20) durch eine Sammelschiene parallel 30 angeordnet sind.

6. Solarziegelstruktur nach Anspruch 1, wobei eine Seite der Rückwand (25), die dem Zellenpaket (24) zugewandt ist, mit einer ersten schwarzen Beschichtung (251) ausgebildet ist und eine Dicke der Rückwand (25) größer als 260 µm ist; und
eine dem transparenten Glas (23) zugewandte Seite des Zellenpakets (24) mit einem schwarzen Abschirmstreifen (3) versehen ist, eine dem transparenten Glas (23) zugewandte Seite des schwarzen Abschirmstreifens (3) mit einer zweiten schwarzen Beschichtung (31) ausgebildet ist, und eine Dicke des schwarzen Abschirmstreifens (3) 133µm ± 30 µm beträgt.

7. Solarziegelstruktur nach Anspruch 6, wobei die Rückwand (25) eine Polyvinylidenfluoridfilm-Polyethylenterephthalatfilm-Fluorfilm-Verbundplatte ist.

8. Solarziegelstruktur nach Anspruch 6 oder 7, wobei der schwarze Abschirmstreifen (3) eine Fluorfolien-Polyethylenterephthalat-Folien-Fluorfolien-Verbundplatte ist.

9. Solarziegelstruktur nach Anspruch 1, wobei eine Seite des transparenten Glases (23), die von dem Zellenpaket (24) abgewandt ist, mit einem ersten transparenten Beschichtungsfilm (231) und einem zweiten transparenten Beschichtungsfilm (232) ausgebildet ist, die aufeinanderfolgend gestapelt sind; und
eine Dicke der ersten transparenten Beschichtungsschicht (231) 85 µm bis 100 µm beträgt; oder eine Dicke der zweiten transparenten Beschichtungsschicht (232) 75 µm bis 90 µm beträgt; oder
die Dicke der ersten transparenten Beschichtungsschicht (231) 85 µm bis 100 µm und die Dicke der zweiten transparenten Beschichtungsschicht (232) 75 µm bis 90 µm beträgt.

## Revendications

1. Structure de tuile solaire, comprenant : un module de cellules solaires (2) et une tuile (1), dans laquelle la tuile (1) a une première surface latérale et une deuxième surface latérale disposées de façon opposée dans une direction d'épaisseur de la tuile (1), la première surface latérale est munie d'une rainure d'encastrement (11), et le module de cellules solaires (2) est encastré dans la rainure d'encastrement (11) ; et
la tuile (1) est munie d'un orifice de désassemblage (12), et l'orifice de désassemblage (12) est configuré pour permettre au module de cellule solaire (2) d'être détaché de la rainure d'encastrement (11) ;
dans lequel le module de cellules solaires (2) comprend un verre transparent (23), un bloc de cellules (24) et un panneau arrière (25) qui sont empilés séquentiellement dans une direction allant de la première surface latérale à la deuxième surface latérale, et deux surfaces latérales du bloc de cellules (24) dans une direction d'épaisseur du bloc de cellules (24) sont respectivement collées au verre transparent (23) et au panneau arrière (25) ;
la structure de la tuile solaire est **caractérisée en ce que** le bloc de cellules (24) a un câble positif (21) et un câble négatif (22), et le câble positif (21) et le câble négatif (22) sont situés à une même extrémité du bloc de cellules (24) dans une direction de longueur du bloc de cellules (24) ; et
l'orifice de désassemblage (12) est situé à un emplacement où une paroi latérale de la rainure d'encastrement entre en contact avec la première surface latérale, ladite paroi latérale s'étendant dans le sens de la longueur.

2. Structure de tuiles solaires selon la revendication 1, dans laquelle une position de la première surface latérale où la rainure d'encastrement (11) n'est pas disposée est munie d'un orifice de montage (13) pénétrant à travers la tuile (1), et l'orifice de montage (13) est configuré pour connecter de façon amovible la tuile (1) à une volige (5) par l'intermédiaire d'une fixation.

3. Structure de tuiles solaires selon la revendication 1, dans laquelle la tuile (1) est munie d'une saillie (14) et d'une rainure (15), la saillie (14) étant configurée pour être connectée à une rainure (15) sur une autre tuile (1) adjacente à la tuile (1) par insertion, et la rainure (15) étant configurée pour être connectée à une saillie (14) sur une autre tuile (1) adjacente à la tuile (1) par insertion.

4. Structure de tuile solaire selon la revendication 3, dans laquelle l'une parmi la rainure (15) et la saillie (14) est disposée sur la première surface latérale, et l'autre parmi la saillie (14) et la rainure (15) est disposée sur la deuxième surface latérale.

5. Structure de tuiles solaires selon la revendication 1, dans laquelle le bloc de cellules (24) comprend une pluralité de chaînes de batteries (20) disposées en séquence, et la pluralité de chaînes de batteries (20) sont disposées en parallèle au moyen d'une barre omnibus.

6. Structure de tuile solaire selon la revendication 1, dans laquelle un côté du panneau arrière (25) faisant face au bloc de cellules (24) est formé avec un premier revêtement noir (251), et une épaisseur du panneau arrière (25) est supérieure à 260 um ; et
un côté du bloc de cellules (24) faisant face au verre transparent (23) est muni d'une bande de protection noire (3), un côté de la bande de protection noire (3) faisant face au verre transparent (23) est formé d'un deuxième revêtement noir (31), et une épaisseur de la bande de protection noire (3) est de 133 µm ± 30 um.

7. Structure de tuile solaire selon la revendication 6, dans laquelle le panneau arrière (25) est une plaque composite film de fluorure de polyvinylidène - film de téréphtalate de polyéthylène - film fluoré.

8. Structure de tuile solaire selon la revendication 6 ou 7, dans laquelle la bande noire de protection (3) est une plaque composite film fluoré - film de téréphtalate de polyéthylène - film fluoré.

9. Structure de tuile solaire selon la revendication 1, dans laquelle un côté du verre transparent (23) opposé au bloc de cellules (24) est formé avec un premier film de revêtement transparent (231) et un deuxième film de revêtement transparent (232) qui sont empilés de façon séquentielle ; et
l'épaisseur du premier film de revêtement transparent (231) est comprise entre 85 um et 100 um ; ou
l'épaisseur du deuxième film de revêtement transparent (232) est comprise entre 75 µm et 90 um ; ou
une épaisseur du premier film de revêtement transparent (231) est comprise entre 85 um et 100 um, et une épaisseur du deuxième film de revêtement transparent (232) est comprise entre 75 µm et 90 µm.
